# EUROPÄISCHE PATENTANMELDUNG

(11) **EP 2 690 453 A1**
(43) Veröffentlichungstag der Anmeldung: **29.01.2014**
(21) Anmeldenummer: 12178232.0
(22) Anmeldetag: 27.07.2012
(51) Int. Cl.: G01R 31/34, H02K 15/00, G01R 31/04

(54) **Anordnung zur Überwachung eines elektrischen Kontakts**

(71) Anmelder: Siemens Aktiengesellschaft, 80333 München (DE)
(72) Erfinder: Kowalski, Waldemar, 45472 Mülheim an der Ruhr (DE); Lehmann, Christoph, 47506 Neukirchen-Vluyn (DE)

(57) **Zusammenfassung**

Die Erfindung betrifft eine Anordnung (1) zur Überwachung der Güte eines elektrischen Kontakts (2) in einem Generator, wobei die Güte des elektrischen Kontakts mittels einer Infrarotkamera (3) detektiert und während des Betriebs erfasst wird.

## Beschreibung

Die Erfindung betrifft eine Anordnung und ein Verfahren zur Überwachung eines elektrischen Kontakts.

Elektrische Generatoren weisen im Wesentlichen einen um eine Drehachse rotierbar gelagerten Rotor und einen um den Rotor angeordneten fest fixierten Stator auf. Der Rotor weist eine elektrisch leitende Rotorwicklung und der Stator eine elektrisch leitende Statorwicklung auf. Im Betrieb wird über geeignete Mittel die Rotorwicklung mit Strom beaufschlagt, so dass durch eine Rotation des Rotors ein drehendes Magnetfeld entsteht, das in der Ständerwicklung eine elektrische Spannung induziert. Ein elektrischer Generator umfasst somit elektrische Leitungen, die nicht durchgängig ausgebildet sind, sondern an verschiedenen Stellen elektrische Kontakte aufweisen. Solch elektrische Kontakte sollten eine dauerhaft gute Verbindung aufweisen, damit die elektrische Leitfähigkeit der zusammengeführten Kontaktpartner gewährleistet ist.

Es kann durchaus vorkommen, dass zwischen zwei Kontaktpartnern eine unzureichende Leitfähigkeit entsteht, die verschiedene Ursachen haben kann, wie z.B. Montagemängel, aber auch Herstellungsmängel, wie bspw. unzulässige Toleranzabweichungen. Des Weiteren kann die Leitfähigkeit geringer werden durch im Betrieb auftauchende Schwingungen, die zu einem Schaden im elektrischen Kontakt führen.

Ein mangelhafter Kontakt zwischen zwei Kontaktpartnern kann zu schwerwiegenden Fehlern führen. Der Zustand der elektrischen Verbindungen bzw. elektrischer Kontakte muss daher überprüft werden, um Ausfälle zu vermeiden. Es muss somit eine Verbindungsdiagnose bzw. Kontaktdiagnose durchgeführt werden. Dabei wird ein physikalischer Effekt ausgenutzt, bei dem eine unzureichende Kontaktierung zu einer Erhöhung des Durchgangswiderstandes zwischen den beiden Kontaktpartnern führt und dadurch eine deutliche Erwärmung der Kontaktstelle mit sich bringt. Das bedeutet, dass eine fehlerhafte elektrische Verbindung bzw. ein fehlerhafter elektrischer Kontakt über eine Temperaturentwicklung detektiert werden kann.

Somit führt eine ungenügende elektrische Kontaktierung zu einem erhöhten Übergangswiderstand und damit zu einer erhöhten Wärmeabgabe.

An dieser Stelle setzt die Erfindung an. Aufgabe der Erfindung ist es, eine Anordnung und ein Verfahren anzugeben, mit dem die Güte eines elektrischen Kontakts überprüft werden kann.

Gelöst wird dies durch eine Anordnung zur Überwachung eines elektrischen Kontakts mit einer Infrarotkamera, die mit einer Automatisierungseinrichtung verbunden ist, wobei die Automatisierungseinrichtung derart ausgebildet ist, dass in regelmäßigen zeitlichen Abständen eine Aufnahme erstellt wird.

Die auf das Verfahren hin gerichtete Aufgabe wird gelöst durch ein Verfahren zur Überwachung von elektrischen Kontakten in einem elektrischen Generator, wobei mittels einer Infrarotkamera Aufnahmen von dem elektrischen Kontakt erstellt werden.

Erfindungsgemäß wird somit vorgeschlagen, eine Anordnung anzubieten, die im Betrieb eingesetzt werden kann. Eine Infrarotkamera ist bekanntermaßen derart ausgebildet, dass Wärme mittels eines geeigneten Bildgebungsverfahrens visualisiert werden kann. Dabei wird die Temperatur in verschiedenen Farben dargestellt. Die Infrarotkamera wird nun derart angeordnet, dass ein elektrischer Kontakt regelmäßig überprüft werden kann. Erfindungsgemäß wird in regelmäßigen Abständen eine Aufnahme einer elektrischen Verbindung erstellt. Dies erfolgt primär in einer Automatisierungseinrichtung, die mit der Infrarotkamera verbunden ist und derart ausgebildet ist, dass regelmäßig in zeitlichen Abständen eine Aufnahme automatisiert durchgeführt wird.

Vorteilhafterweise wird die Automatisierungseinrichtung mit einer Auswerteeinrichtung verbunden, die derart ausgebildet ist, dass ein Alarm losgeht, sobald die Aufnahme Unterschiede aufweist. Das bedeutet, dass, sobald die Güte des elektrischen Kontakts sich verschlechtert und eine Temperaturerhöhung zur Folge hat, die zeitlich veränderbar ist. Die zeitliche Veränderung der Temperaturerhöhung wird mit der Auswerteeinrichtung erfasst und derart mit der Auswerteeinrichtung verarbeitet, dass ein Signal bzw. ein Alarm losgeht, sobald zeitlich aufeinanderfolgende Bildaufnahmen der Infrarotkamera einen Grenzwert überschreiten.

Zweckdienlicherweise wird davon ausgegangen, dass die gemessene Temperatur proportional zum Kontaktwiderstand ist und somit ein Maß der Güte des elektrischen Widerstands darstellt. Die aufgezeichneten Werte können direkt visuell in entsprechenden Diagrammen betrachtet und mit einer zulässigen Grenztemperatur verglichen werden.

Durch die erfindungsgemäße Anordnung wird somit eine Online-Überwachung ermöglicht, die leicht und zuverlässig sowie zeitnah den Zustand eines elektrischen Kontakts ermittelt.

Des Weiteren können voreingestellte und definierte Parameter zu weiteren Prozessabfolgen in der Signalverarbeitung führen, wie z.B. eine Warnung abgegeben sowie einen Alarm erstellen.

Die Ausgangssignale der Infrarotkamera können ebenso dazu verwendet werden, eine Stromreduzierung durch den elektrischen Kontakt herbeizuführen, indem eine Regelung angesteuert wird, die zu einer Stromreduzierung im elektrischen Kontakt führt. Eine zusätzliche Maßnahme, mit der die Ausgangsdaten der Infrarotkamera ausgewertet werden können, ist durch die Mobilisierung einer zusätzlichen Kühlung möglich. Das bedeutet, dass, sobald eine Grenztemperatur erreicht oder sogar überschritten wird, die Auswerteeinrichtung ein Signal auslöst, wobei eine Kühleinrichtung aktiviert wird, die den betroffenen elektrischen Kontakt kühlt und somit die Temperatur des elektrischen Kontakts verringert.

Die Erfindung wird anhand eines Ausführungsbeispiels näher erläutert.

Es zeigt:
- Figur: eine schematische Darstellung einer Anordnung zur Überwachung.

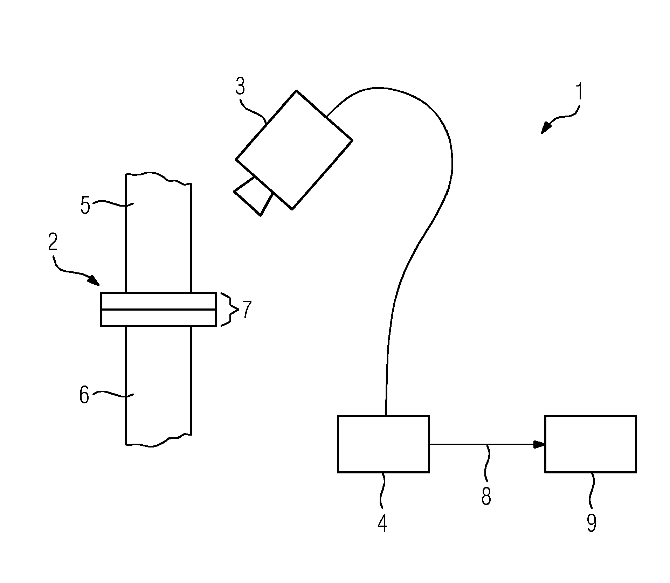

Die Figur zeigt in schematischer Weise eine Anordnung 1 zur Überwachung eines elektrischen Kontakts 2 mit einer Infrarotkamera 3, die mit einer Automatisierungseinrichtung 4 verbunden ist, wobei die Automatisierungseinrichtung 4 derart ausgebildet ist, dass in regelmäßigen zeitlichen Abständen eine Aufnahme erstellt wird. Der elektrische Kontakt 2 umfasst einen ersten elektrischen Kontaktpartner 5 und einen zweiten elektrischen Kontaktpartner 6. Der erste elektrische Kontaktpartner 5 und der zweite elektrische Kontaktpartner 6 sind über eine geeignete mechanische Verbindung 7 elektrisch miteinander in Kontakt gebracht. Die Infrarotkamera 3 wird derart aufgestellt, dass bildliche Aufnahmen des elektrischen Kontakts 2 aufgenommen werden und zwar in zeitlich regelmäßigen Abständen. Über die Änderungen dieser in zeitlich regelmäßigen Abständen aufgenommenen Aufnahmen wird die Güte des elektrischen Kontakts 2 ermittelt. Das bedeutet, dass eine Erhöhung der Temperatur des elektrischen Kontakts 2 über die Infrarotkamera detektiert wird.

Die Automatisierungseinrichtung 4 ist über eine Datenleitung 8 mit einer Auswerteeinrichtung 9 verbunden. Die Auswerteeinrichtung 9 ist derart ausgebildet, dass ein Alarm losgeht, sobald die Aufnahmen Unterschiede aufweisen. Somit ist die gesamte Anordnung 1 ausgebildet zur Überwachung des elektrischen Kontakts 2 in einem Generator. Darüber hinaus wird die Infrarotkamera 3 sowie die Automatisierungseinrichtung 4 und die Auswerteeinrichtung 9 derart ausgebildet, dass eine Überwachung während des Betriebs des elektrischen Generators möglich ist.

## Patentansprüche

1. Anordnung (1) zur Überwachung eines elektrischen Kontakts (2) mit einer Infrarotkamera (3), die mit einer Automatisierungseinrichtung (4) verbunden ist,
wobei die Automatisierungseinrichtung (4) derart ausgebildet ist, dass in regelmäßigen zeitlichen Abständen eine Aufnahme erstellt wird.

2. Anordnung (1) nach Anspruch 1,
wobei die Infrarotkamera (3) zur bildlichen Aufnahme des elektrischen Kontakts (2) ausgebildet ist.

3. Anordnung (1) nach Anspruch 1,
mit einer Auswerteeinrichtung (9), die derart ausgebildet ist, dass ein Alarm losgeht, sobald die Aufnahmen Unterschiede aufweisen.

4. Anordnung (1) nach Anspruch 1, 2 oder 3,
ausgebildet zur Überwachung eines elektrischen Kontakts (2) in einem Generator.

5. Anordnung (1) nach Anspruch 4,
ausgebildet zur Überwachung während des Betriebs des elektrischen Generators.

6. Verfahren zur Überwachung von elektrischen Kontakten (2) in einem elektrischen Generator,
wobei mittels einer Infrarotkamera (3) Aufnahmen von dem elektrischen Kontakt (2) erstellt werden.

7. Verfahren nach Anspruch 6,
wobei die Aufnahmen während des Betriebs des elektrischen Generators erstellt werden.

8. Verfahren nach Anspruch 6 oder 7,
wobei ein automatischer Alarm losgeht, wenn zwischen zwei Aufnahmen ein Unterschied erkannt wird.
